# EUROPEAN PATENT APPLICATION

(11) **EP 4 646 053 A1**
(43) Date of publication of application: **05.11.2025**
(21) Application number: 25173037.0
(22) Date of filing: 28.04.2025
(51) Int. Cl.: H10D 30/01, H10D 30/47, H10D 62/13

(54) **METHOD FOR MAKING DEPLETION-MODE HIGH-ELECTRON-MOBILITY TRANSISTOR**

(30) Priority: 30.04.2024 TW 113116094
(71) Applicant: Ultraband Technologies Inc., Zhubei City Hsinchu County 302058 (TW)
(72) Inventor: WU, Chan-Shin, 302058 Zhubei City, Hsinchu County (TW)
(74) Representative: 2K Patentanwälte Blasberg Kewitz & Reichel

(57) **Abstract**

The manufacturing method of the depletion-mode high electron mobility transistor of the present invention comprises the following steps: (a) providing a semiconductor substrate comprising a channel layer and a barrier layer above the channel layer, (b) isolating a platform, (c) forming a dielectric layer above the semiconductor substrate, (d) forming a first field plate above the dielectric layer, (e) forming a second field plate above the first field plate, (f) patterning the first field plate and the second field plate to expose the position of the dielectric layer in relation to a source opening, a gate opening, and a drain opening, (g) patterning the dielectric layer to expose the position of semiconductor substrate in relation to the source opening and the drain opening, (h) patterning an ohmic contact metal layer to cover the position of the semiconductor substrate in relation to the source opening and the drain opening, and alloying the ohmic contact metal layer.

## Description

### BACKGROUND OF THE INVENTION

### 1. Technical Field

The present invention relates to a method for making a transistor. More particularly, the invention relates to, but is not limited to, a method for making a depletion-mode high-electron-mobility transistor.

### 2. Description of Related Art

In the semiconductor industry, high-voltage switching transistors such as high-electron-mobility transistors (HEMTs), junction field-effect transistors (JFETs), and power metal-oxide-semiconductor field-effect transistors (power MOSFETs) are often used as semiconductor switching elements of high-voltage high-power devices. High-electron-mobility transistors, in particular, have gradually come into extensive use because they have high power densities, high breakdown voltages, high output voltages, and high switching frequencies, among other advantages, and therefore cause little, if any, damage to devices in a high-voltage operating environment.

The superior properties of high-electron-mobility transistors depend mostly on such material properties of gallium nitride (GaN) as a wide bandgap, a high critical electric field, and high carrier mobility. In addition, the unique polarization effect of GaN makes it possible for aluminum gallium nitride (AlGaN)/GaN, a heterostructure, to form a two-dimensional electron gas (2DEG) through induction at the interface when undoped, and hence for AlGaN/GaN HEMTs to output a high current during operation and have very low ON resistance at the same time.

In practice, a high-electron-mobility transistor can be provided as an enhancement-mode (E-mode) semiconductor device with a positive threshold voltage or a depletion-mode (D-mode) high-electron-mobility transistor with a negative threshold voltage.

### [BRIEF SUMMARY OF THE INVENTION]

In the prior art, methods for making a depletion-mode high-electron-mobility transistor typically involve preparing the ohmic-contact metal layer prior to the other layers, and this is because the formation of the ohmic-contact metal layer generally uses a relatively high process temperature that may hinder nitride deposition. Once the ohmic-contact metal layer is formed, however, the method for use in forming the nitride dielectric layer is limited. Low-pressure chemical vapor deposition (low-pressure CVD, or LPCVD), which is originally suitable for forming the nitride dielectric layer, is no longer useful because it must be kept from metal contamination. As a result, the complexity and difficulty of patterning/etching are increased. For example, in order to perform patterning/etching in a precisely controlled manner, a special etching process must be used, and during the etching process, care must be taken not to etch the underlying layers or contaminate the metal of the electrodes, the objective being to prevent the resulting device from leaking electricity or malfunctioning. The special etching process includes atomic layer etching (ALE), which uses sequential self-limiting reactions to remove a thin layer of material but is disadvantaged by its high cost, high technical threshold, and being time-consuming.

In view of the problems stated above, and believing that the temperature of the manufacturing process of an ohmic-contact metal layer can already be lowered to under 600°C and therefore has a weaker effect on the deposition of a nitride dielectric layer than before, the inventor of the present invention conceived a method for making a depletion-mode high-electron-mobility transistor in which the ohmic-contact metal layer is provided after the nitride dielectric layer so that an LPCVD process or a plasma-enhanced CVD (PECVD) process can be used in a timely manner to form the nitride dielectric layer. Now that there is no need to consider the risk that the stage of forming a plurality of nitride dielectric layers is subject to metal contamination, the method is more flexible than its prior art counterparts. Moreover, the invention can take advantage of the properties of different epitaxial growth or deposition processes so that transistor patterning can be subsequently carried out in a more effective and easy way than with the prior art.

A method for making a depletion-mode high-electron-mobility transistor, comprises the steps of: (a) providing a semiconductor substrate, wherein the semiconductor substrate comprises a channel layer and a barrier layer provided above the channel layer; (b) forming an isolated platform; (c) forming a dielectric layer above the semiconductor substrate; (d) forming a first field plate above the dielectric layer; (e) forming a second field plate above the first field plate; (f) patterning the first field plate and the second field plate in order to expose portions of the dielectric layer that correspond to a source opening, a gate opening, and a drain opening; (g) patterning the dielectric layer in order to expose portions of the semiconductor substrate that correspond to the source opening and the drain opening; and (h) forming an ohmic-contact metal layer in a patterned manner such that the ohmic-contact metal layer covers the portions of the semiconductor substrate that correspond to the source opening and the drain opening, and alloying the ohmic-contact metal layer.

In one embodiment of the present invention, the method further includes the steps of: (i) forming a metal layer in a patterned manner such that the metal layer covers not only portions of the ohmic-contact metal layer that correspond to the source opening and the drain opening, but also the portion of the dielectric layer that corresponds to the gate opening; and (j) forming a protective layer in a patterned manner such that the protective layer exposes portions of the metal layer that correspond to the source opening and the drain opening.

In one embodiment of the present invention, the protective layer comprises a silicon nitride and has a thickness in a range from 1500 to 3500 Å.

In one embodiment of the present invention, the semiconductor substrate further includes a cap layer above the barrier layer.

In one embodiment of the present invention, the step (b) of forming the isolated platform comprises an isolation implantation step.

In one embodiment of the present invention, the step (c) of forming the dielectric layer uses a low-pressure chemical vapor deposition (LPCVD) process.

In one embodiment of the present invention, the dielectric layer comprises a silicon nitride and has a thickness in a range from 450 to 750 Å.

In one embodiment of the present invention, the step (d) of forming the first field plate uses a plasma-enhanced chemical vapor deposition (PECVD) process.

In one embodiment of the present invention, the step (e) of forming the second field plate uses a plasma-enhanced chemical vapor deposition process.

In one embodiment of the present invention, the first field plate comprises a silicon nitride and has a thickness in a range from 1500 to 3500 Å.

In one embodiment of the present invention, the second field plate comprises a silicon nitride and has a thickness in a range from 2500 to 4000 Å.

In one embodiment of the present invention, the step (d) further includes: forming an etching stop layer above the first field plate.

In one embodiment of the present invention, said forming the etching stop layer uses a low-pressure chemical vapor deposition process, and the low-pressure chemical vapor deposition process uses a process temperature lower than 800°C.

In one embodiment of the present invention, the etching stop layer comprises a silicon nitride and has a thickness in a range from 75 to 150 Å.

In one embodiment of the present invention, in the step (h) of forming the ohmic-contact metal layer, said alloying uses a process temperature in a range from 300°C to 600°C.

In the method provided by the present invention for making a depletion-mode high-electron-mobility transistor, the preparation of the various dielectric layers (including a dielectric layer, a first field plate, an etching stop layer, and a second field plate) can be completed before the ohmic-contact metal layer is formed, and this allows the manufacturing processes of the layers to be arranged more flexibly than in the prior art, making it possible for the invention to use the properties of different epitaxial growth or deposition processes and pattern the transistor more effectively and easily in subsequent steps than with the prior art, without having to use any special manufacturing process that is conventionally required.

### BRIEF DESCRIPTION OF THE SEVERAL VIEWS OF THE DRAWINGS

The foregoing and other objectives, as well as the features and advantages, of the present invention can be better understood by referring to the following description of some embodiments of the invention in conjunction with the accompanying drawings, in which:
FIG. 1 and FIG. 2 are the flowcharts of the method in an embodiment of the invention for making a depletion-mode high-electron-mobility transistor; and
FIG. 3 to FIG. 12 are sectional views showing different stages of the structure of a depletion-mode high-electron-mobility transistor made by the method in the embodiment of the invention.

As is conventional, the features and elements in the drawings are not drawn to scale but are drawn to best show specific features and elements that are related to the present invention. In addition, similar elements and parts are designated by identical or similar reference numerals in different drawings.

### DETAILED DESCRIPTION OF THE INVENTION

To describe the present invention in detail and in full, an illustrative description of some modes of implementation and embodiments of the invention is given below, but those modes of implementation and embodiments are not the only ways in which the invention can be used or implemented. Unless otherwise stated in the context, "a" and "the" as used in the present specification and the appended claims may connote plurality. Besides, unless otherwise stated in the context, the phrase "provided on an object" as used in the present specification and the appended claims can be regarded as making contact with a surface of the object either directly or indirectly through adhesive attachment or other means, wherein the definition of the surface shall be determined according to the context and common general knowledge in the field to which the invention pertains.

While approximate values are used to define the numerical ranges and parameters in the present invention, such values of the embodiments have been presented herein as precisely as possible. All values, however, have intrinsically unavoidable standard deviations caused by individual testing methods. Herein, "about" generally means that the actual value is within ±10%, 5%, 1%, or 0.5% of a specific value or range. Or, the term "about" means that the actual value falls within a range of acceptable standard errors of a mean, wherein the range can be determined by a person of ordinary skill in the field to which the invention pertains. Therefore, unless otherwise stated, all the values disclosed in the present specification and the appended claims are approximate values and may vary as needed. Those numerical parameters should at least be understood as values obtained by applying a common carry method to the specified significant figures.

### Terminology

As used herein, the term "high-electron-mobility transistor" may refer to an enhancement-mode (E-mode) semiconductor device or a depletion-mode (D-mode) high-electron-mobility transistor, wherein the depletion-mode high-electron-mobility transistor may be a normally ON structure with a negative threshold voltage or a normally OFF structure with a positive threshold voltage. In addition, the "semiconductor material" in the present invention may include chemical compounds of various elements, wherein the elements include but are not limited to elements in the same groups in the periodic table as those of the elements in GaN, such as a matched combination of one or more elements in group 13 (i.e., the group including boron (B), aluminum (Al), gallium (Ga), indium (In), and thallium (Tl)) and one or more elements in group 15 (i.e., the group including nitrogen (N), phosphorus (P), arsenic (As), antimony (Sb), and bismuth (Bi)), or a matched combination of elements in group 14 (i.e., the group including carbon (C), silicon (Si), germanium (Ge), and Tin (Sn)) such as silicon carbide (SiC) or a silicon-germanium alloy. Groups 13 to 15 in the period table are also known as groups III, IV, and V.

As used herein, the term "exposure" refers to a condition or configuration in which a surface of an object is not completely covered and in which the surface of the object may form one or a plurality of openings or holes. The specific definition of the term, however, shall be determined according to the context and common general knowledge in the field to which the present invention pertains.

As used herein, the term "suitable epitaxial growth or deposition process" includes but is not limited to chemical vapor deposition (CVD), low-pressure CVD (LPCVD), atmospheric-pressure CVD (APCVD), ultrahigh-vacuum CVD (UHVCVD), atomic layer deposition (ALD), molecular layer deposition (MLD), plasma-enhanced CVD (PECVD), metal-organic CVD (MOCVD), molecular beam epitaxy (MBE), sputtering, or a combination of the above.

As used herein, the term "photoresist" refers to a photosensitive material that is commonly used in the processing processes of integrated circuits and semiconductor devices, and that shows differences in solubility when irradiated with, for example, ultraviolet light, deep ultraviolet light, an electron beam, an ion beam, or an X-ray so that a pattern can be formed on a surface of an object according to the user's purpose. A photoresist can be categorized as a positive photoresist or a negative photoresist. After exposure to light and development, a positive photoresist produces the same pattern as the mask/reticle being used, whereas a negative photoresist produces the inverse, or negative, pattern of the mask/reticle.

As used herein, the term "mask/reticle" refers to a masking device that is commonly used in the processing processes of integrated circuits and semiconductor devices to define the pattern to be formed on a surface of an object, and that works with a photoresist to carry out patterning.

As used herein, the term "lift-off process" refers to a process that includes: applying a negative photoresist (i.e., sacrificial layer) that has the inverse pattern of the area where a metal layer is to be formed; irradiating the photoresist; forming the metal layer; and etching the sacrificial layer away by dissolving such that the metal attached to the sacrificial layer is removed together with the sacrificial layer, which covers the area where the metal layer need not be formed.

As used herein, the term "suitable etching process" includes but is not limited to dry etching or wet etching, wherein dry etching includes such physical bombardment methods as reactive ion etching (RIE) and inductively coupled plasma (ICP) etching, whereas wet etching includes chemical solution etching methods well known in the field to which the present invention pertains.

The following description of the present invention provides the technical contents required for a person of ordinary skill in the art to understand the invention with ease. To adapt to different uses and situations, the invention can be varied and modified in many ways without departing from the spirit or scope of the invention, and all such alternative modes of implementation shall also fall within the scope of the claims of the invention.

### Embodiments

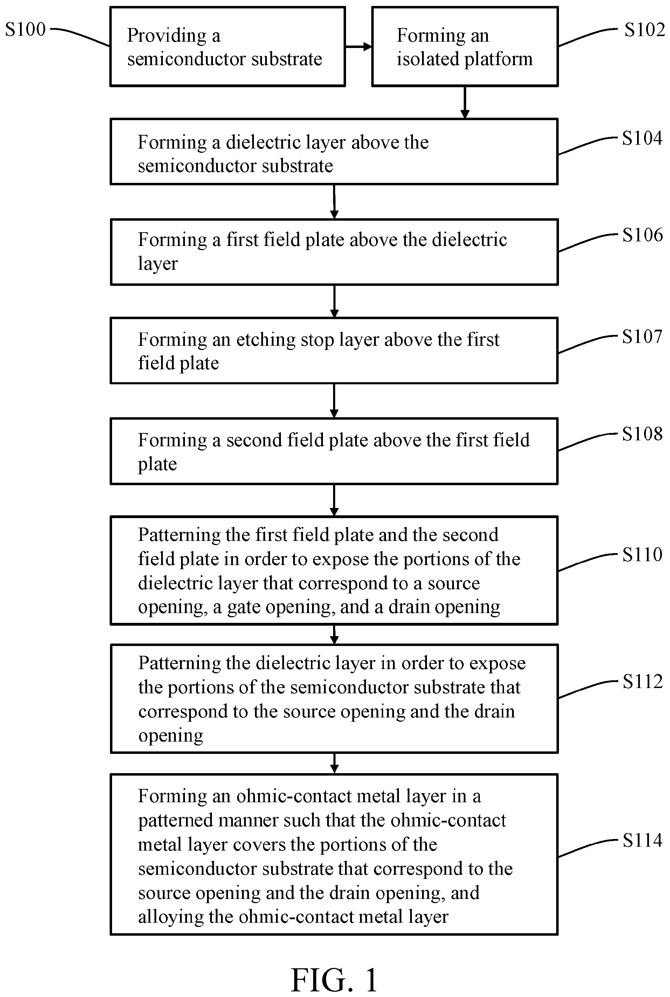

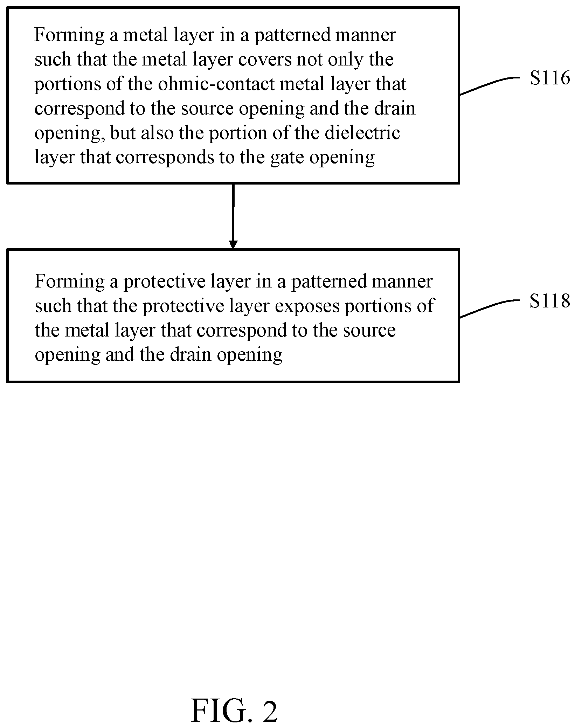

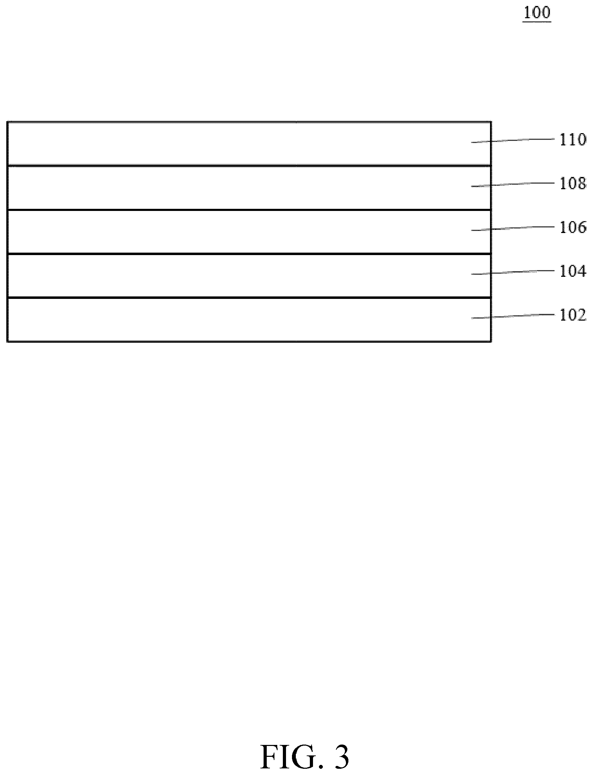

FIG. 1 and FIG. 2 are the flowcharts of the method in an embodiment of the present invention for making a depletion-mode high-electron-mobility transistor, and FIG. 3 to FIG. 12 are sectional views showing different stages of the structure of a depletion-mode high-electron-mobility transistor made by the method.

Referring to FIG. 1 to begin with, the present invention provides a method for making a depletion-mode high-electron-mobility transistor, and the method generally includes the following steps: step S100: providing a semiconductor substrate; step S102: forming an isolated platform; step S104: forming a dielectric layer above the semiconductor substrate; step S106: forming a first field plate above the dielectric layer; step S108: forming a second field plate above the first field plate; step S110: patterning the first field plate and the second field plate in order to expose the portions of the dielectric layer that correspond to a source opening, a gate opening, and a drain opening; step S112: patterning the dielectric layer in order to expose the portions of the semiconductor substrate that correspond to the source opening and the drain opening; and step S114: forming an ohmic-contact metal layer in a patterned manner such that the ohmic-contact metal layer covers the portions of the semiconductor substrate that correspond to the source opening and the drain opening, and alloying the ohmic-contact metal layer. The method may further include step S107, to be performed between step S106 of forming the first field plate and step S108 of forming the second field plate, of forming an etching stop layer above the first field plate.

Referring to FIG. 2, the method of the present invention for making a depletion-mode high-electron-mobility transistor further includes the following steps: step S116: forming a metal layer in a patterned manner such that the metal layer covers not only the portions of the ohmic-contact metal layer that correspond to the source opening and the drain opening, but also the portion of the dielectric layer that corresponds to the gate opening; and step S118: forming a protective layer in a patterned manner such that the protective layer exposes portions of the metal layer that correspond to the source opening and the drain opening.

Please refer to FIG. 3 in conjunction with FIG. 1. FIG. 3 shows the semiconductor substrate 100 provided in step S100. In some embodiments of the present invention, the semiconductor substrate 100 is a structure provided for an AlGaN/GaN high-electron-mobility transistor and includes epitaxially grown layers. More specifically, the semiconductor substrate 100 includes a channel layer 108 and a barrier layer 110 provided above the channel layer 108, and there is a hetero-material interface between the channel layer 108 and the barrier layer 110 such that a portion of the channel layer 108 that is adjacent to the interface forms a two-dimensional electron gas area. The two-dimensional electron gas area can form a free electron transfer channel when subjected to a bias voltage, thereby enabling electrical coupling between a source and a drain, for example. The material of the channel layer 108 is undoped or unintentionally doped GaN, and the thickness of the channel layer 108 is in the range from 150 to 400 nm, such as any of the following values or a value between any two adjacent ones of the following values: 150 nm, 170 nm, 190 nm, 210 nm, 230 nm, 250 nm, 270 nm, 290 nm, 310 nm, 330 nm, 350 nm, 370 nm, 390 nm, or 400 nm. The material of the barrier layer 110 is undoped or unintentionally doped AlₓGa₁₋ₓN, where x is in the range from about 0.1 to about 1; and the thickness of the barrier layer 110 is in the range from 10 to 40 nm, such as any of the following values or a value between any two adjacent ones of the following values: 10 nm, 15 nm, 20 nm, 25 nm, 30 nm, 35 nm, or 40 nm.

In a preferred embodiment of the present invention, the layers of the semiconductor substrate 100 include, sequentially in a bottom-to-top direction: a base 102, a nucleation layer 104, a buffer layer 106, the channel layer 108, and the barrier layer 110. In a more preferred embodiment, a cap layer (not shown) is additionally provided above the barrier layer 110, and the thickness of the cap layer is in the range from 0 to 3.0 nm, such as any of the following values or a value between any two adjacent ones of the following values: 0 nm, 0.5 nm, 1.0 nm, 0.5 nm, 2.0 nm, 2.5 nm, or 3.0 nm. The base 102 includes a wafer and must be insulated, and the wafer is made of a high-quality monocrystalline silicon semiconductor material for example, such as sapphire, GaN, gallium arsenide (GaAs), a silicon crystal, any polymorph of SiC (including wurtzite), aluminum nitride (AlN), indium phosphide (InP), or other similar base materials for use in a semiconductor device. The nucleation layer 104 may include an undoped or unintentionally doped AlN compound. The buffer layer 106 is provided to compensate for any mismatch between the layers and includes undoped, unintentionally doped or carbon doped GaN.

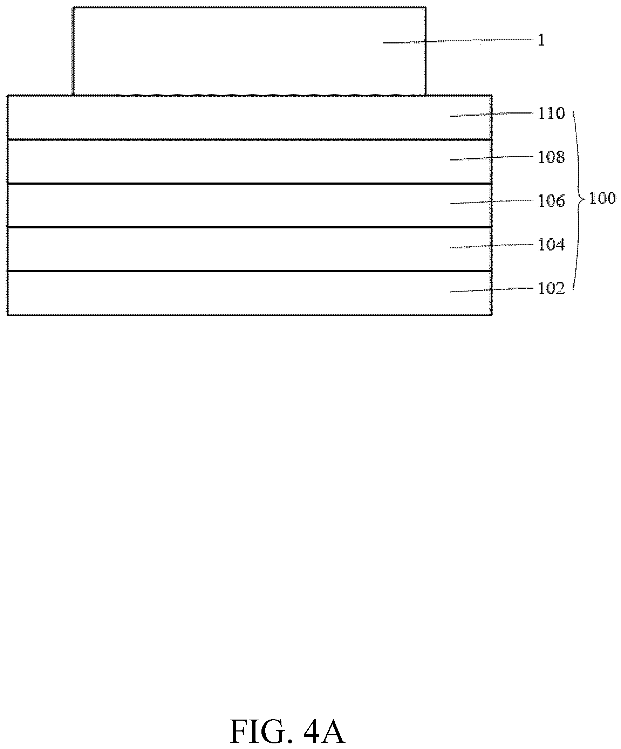

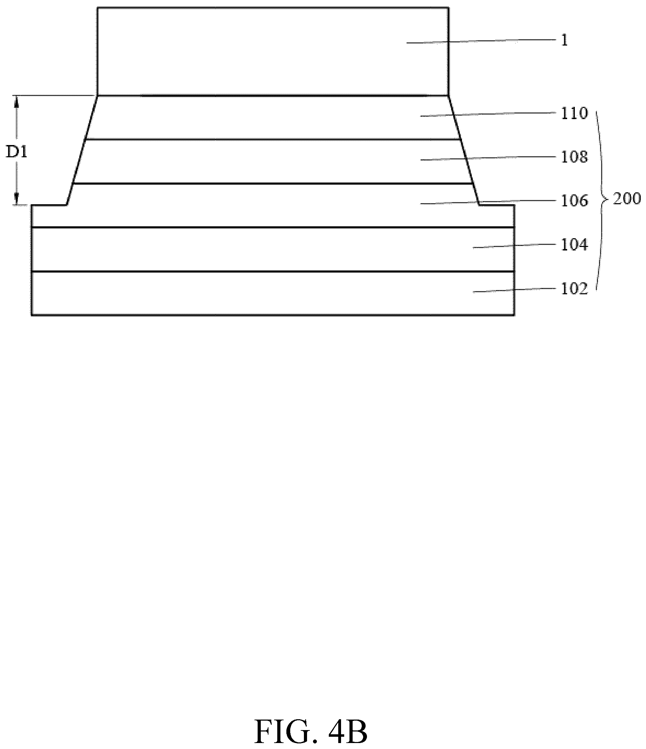

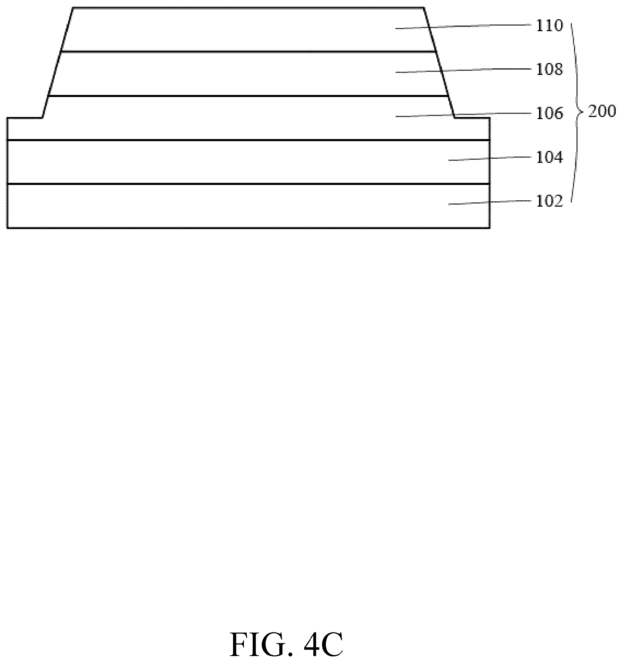

Please refer to FIG. 4A to FIG. 4C in conjunction with FIG. 1. FIG. 4A to FIG. 4C show structural changes that take place when step S102 is performed to form an isolated platform above the semiconductor substrate 100 using a specific mask and/or photoresist. To start with, a photoresist 1 is provided above the semiconductor substrate 100. Then, the semiconductor substrate 100 is etched up to the buffer layer 106 by a suitable etching process. After that, the photoresist 1 is removed to obtain a semiconductor substrate 200 having completed the step of forming an isolated platform. The semiconductor substrate 200 defines an active area, in which electronic elements can operate independently without affecting one another. More specifically, etching the semiconductor substrate 100 up to the buffer layer 106 entails etching the semiconductor substrate 100 to a depth D1 in the range from 1500 to 4500 Å, such as any of the following values or a value between any two adjacent ones of the following values: 1500 A, 2000 Å, 2500 Å, 3000 Å, 3500 Å, or 4000 Å. In one embodiment of the present invention, the step of forming an isolated platform further includes an isolation implantation step, which involves accelerating a particular type of ions in an electric field in order to dope the transistor with the ions. The isolation implantation step can be used to change the electrical resistance of the layers and thereby achieve the objective of defining the active area. The isolation implantation step may be performed after a subsequent high-temperature manufacturing process, or more particularly after a subsequent high-temperature manufacturing process and before the alloying process.

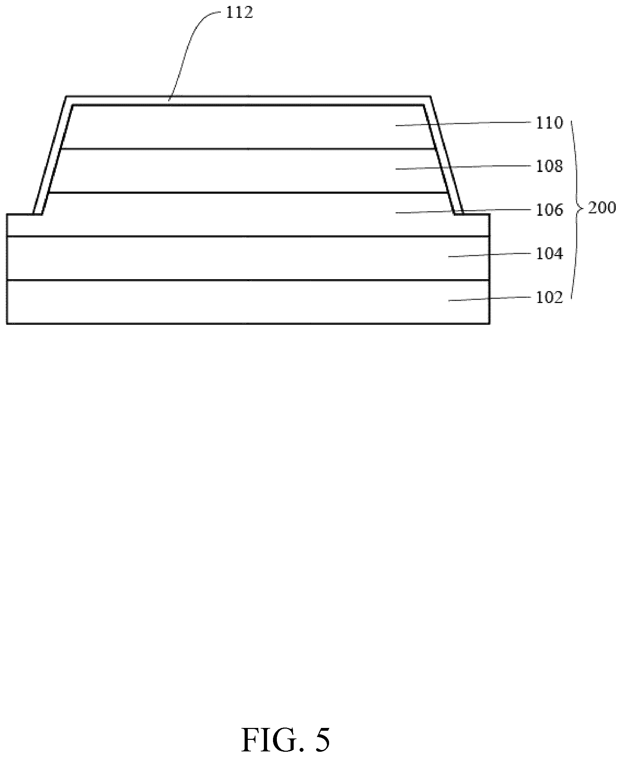

Please refer to FIG. 5 in conjunction with FIG. 1. FIG. 5 shows the structure obtained after performing step S104 to form a dielectric layer 112 above the semiconductor substrate 100. Here, a suitable epitaxial growth or deposition process is used to form the dielectric layer 112 above the semiconductor substrate 200. Preferably, the dielectric layer 112 is formed by LPCVD. Without being bound by any particular theory, using LPCVD to form the dielectric layer 112 in step S104 can effectively prevent metal contamination of the dielectric layer 112 by other manufacturing processes. In a preferred embodiment of the present invention, the thickness of the dielectric layer 112 is in the range from 450 to 750 Å, such as any of the following values or a value between any two adjacent ones of the following values: 450 Å, 500 Å, 550 Å, 600 Å, 650 A, 700 Å, or 750 Å; preferably 550 Å. The material of the dielectric layer 112 includes a silicon nitride, or SiNₓ, where x is in the range from about 0.1 to 1.

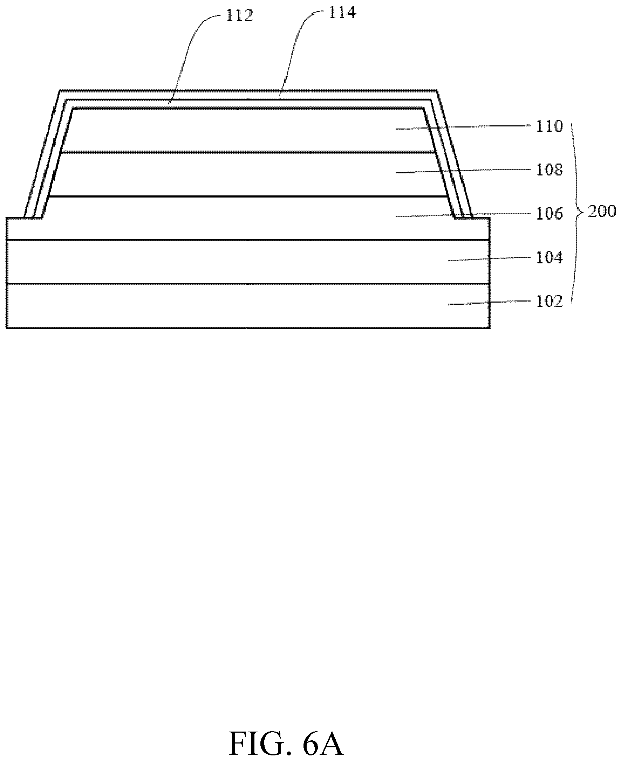

Please refer to FIG. 6A in conjunction with FIG. 1. FIG. 6A shows the structure obtained after performing step S106 to form a first field plate 114 above the dielectric layer 112. Here, a suitable epitaxial growth or deposition process is used to form the first field plate 114 above the dielectric layer 112. Preferably, the first field plate 114 is formed by a manufacturing process different from that used in step S104, such as PECVD. In a preferred embodiment of the present invention, the thickness of the first field plate 114 is in the range from 1500 to 3500 Å, such as any of the following values or a value between any two adjacent ones of the following values: 1500 Å, 1700 Å, 1900 Å, 2100 Å, 2300 Å, 2500 Å, 2700 Å, 2900 Å, 3100 Å, 3300 Å, or 3500 Å; preferably 2500 Å. The material of the first field plate 114 includes a silicon nitride, or SiNₓ, where x is in the range from about 0.1 to 1.

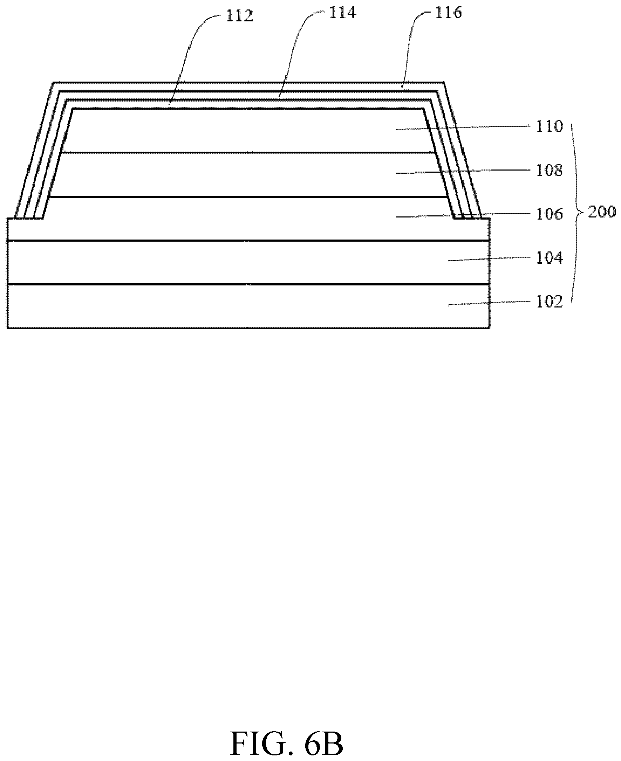

In a preferred embodiment of the present invention, referring to FIG. 6B in conjunction with FIG. 1, step S106 may be followed by step S107 of forming an etching stop layer 116 above the first field plate 114. More specifically, step S107 uses a suitable epitaxial growth or deposition process to form the etching stop layer 116 above the first field plate 114. Preferably, the etching stop layer 116 is formed by a manufacturing process different from that used in step S106, such as LPCVD. Without being bound by any particular theory, LPCVD can be carried out in this step at a relatively low temperature to prevent the layers under the etching stop layer 116 from being damaged. In a preferred embodiment of the invention, the temperature is lower than 800°C, such as lower than 800°C, lower than 750°C, lower than 700°C, or lower than 650°C. In a preferred embodiment of the invention, the thickness of the etching stop layer 116 is in the range from 75 to 150 Å, such as any of the following values or a value between any two adjacent ones of the following values: 75 Å, 85 Å, 95 Å, 105 Å, 115 Å, 125 Å, 135 Å, 145 Å, or 150 Å. The material of the etching stop layer 116 includes a silicon nitride, or SiNₓ, where x is in the range from about 0.1 to 1.

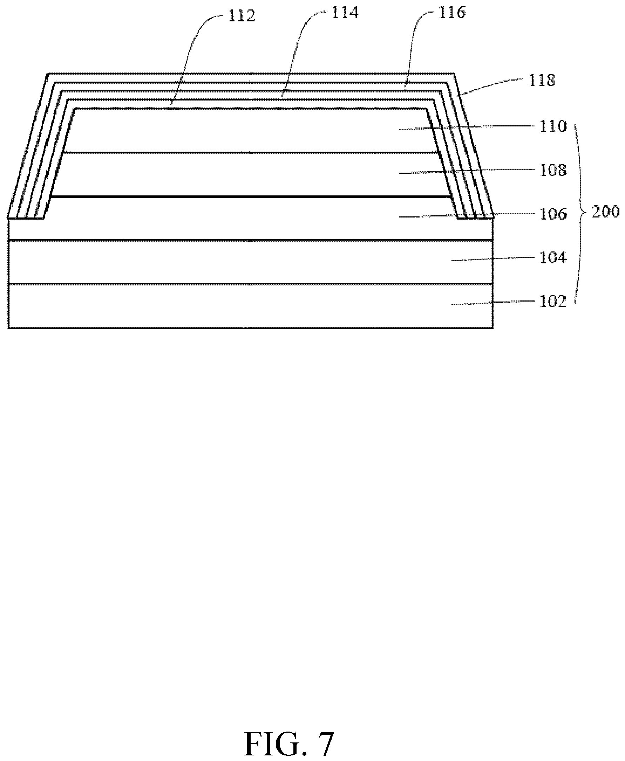

Please refer to FIG. 7 in conjunction with FIG. 1. FIG. 7 shows how a second field plate 118 is formed above the first field plate 114 (or above the etching stop layer 116) in step S108. Here, a suitable epitaxial growth or deposition process is used to form the second field plate 118 above the first field plate 114 (or above the etching stop layer 116). Preferably, the second field plate 118 is formed by a manufacturing process different from that used in step S107, such as PECVD. In a preferred embodiment of the present invention, the thickness of the second field plate 118 is in the range from 2500 to 4000 Å, such as any of the following values or a value between any two adjacent ones of the following values: 2500 Å, 2700 Å, 2900 Å, 3100 Å, 3300 Å, 3500 Å, 3700 Å, 3900 Å, or 4000 Å; preferably 3500 Å. The material of the second field plate 118 includes a silicon nitride, or SiNₓ, where x is in the range from about 0.1 to 1. Without being bound by any particular theory, the first field plate 114 and the second field plate 118 can make the electric field in the channel layer of the depletion-mode high-electron-mobility transistor distribute evenly to increase the breakdown voltage.

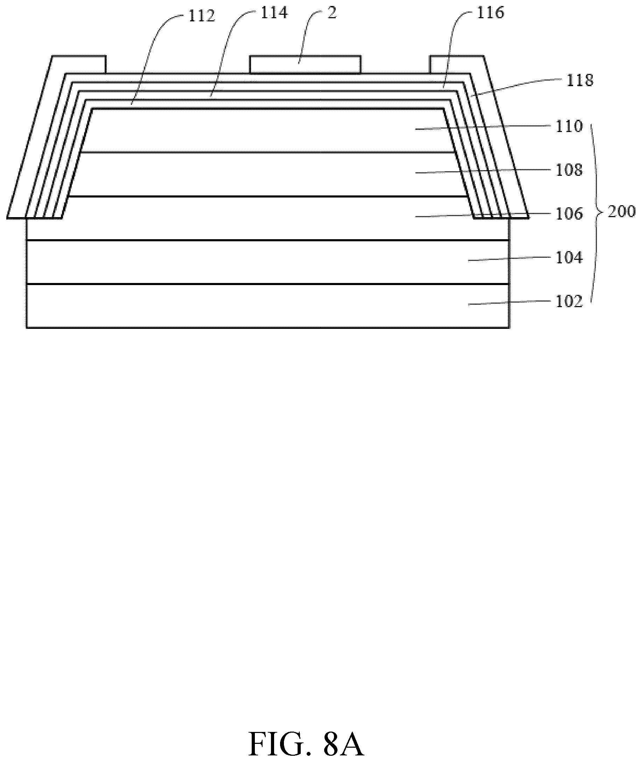

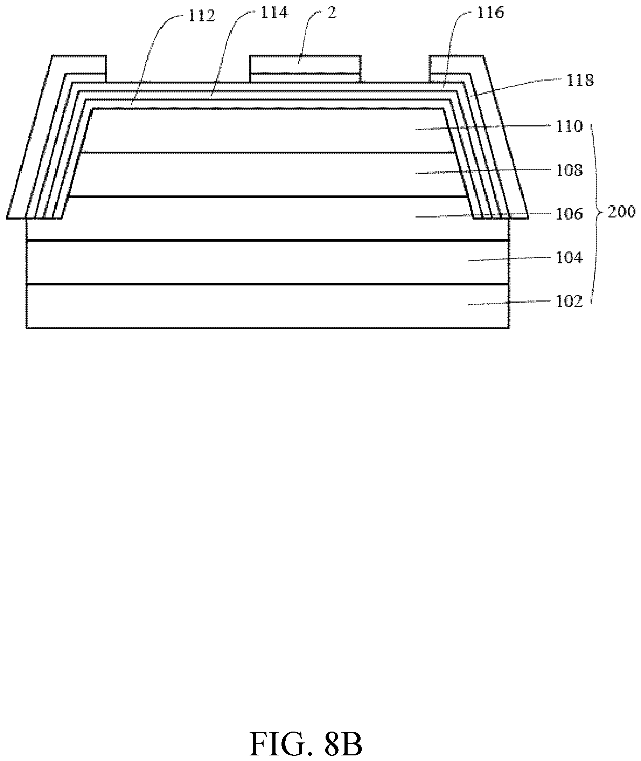

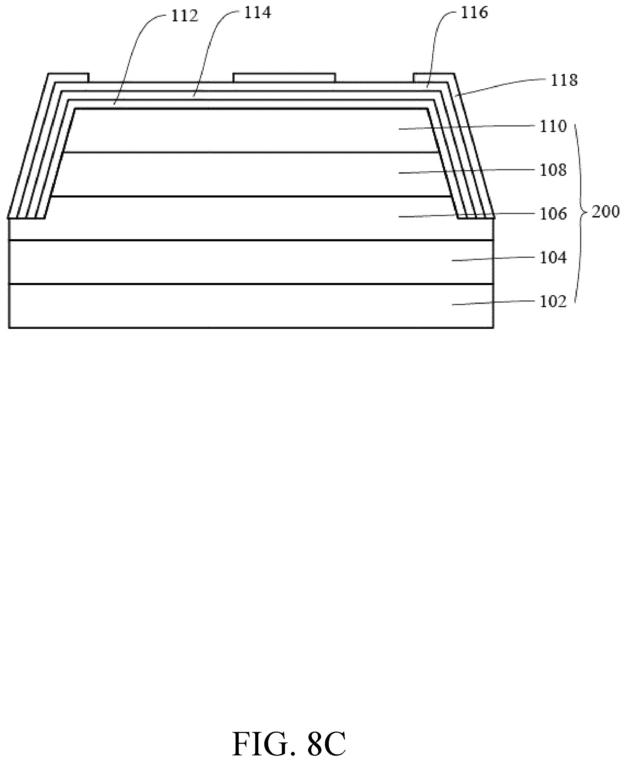

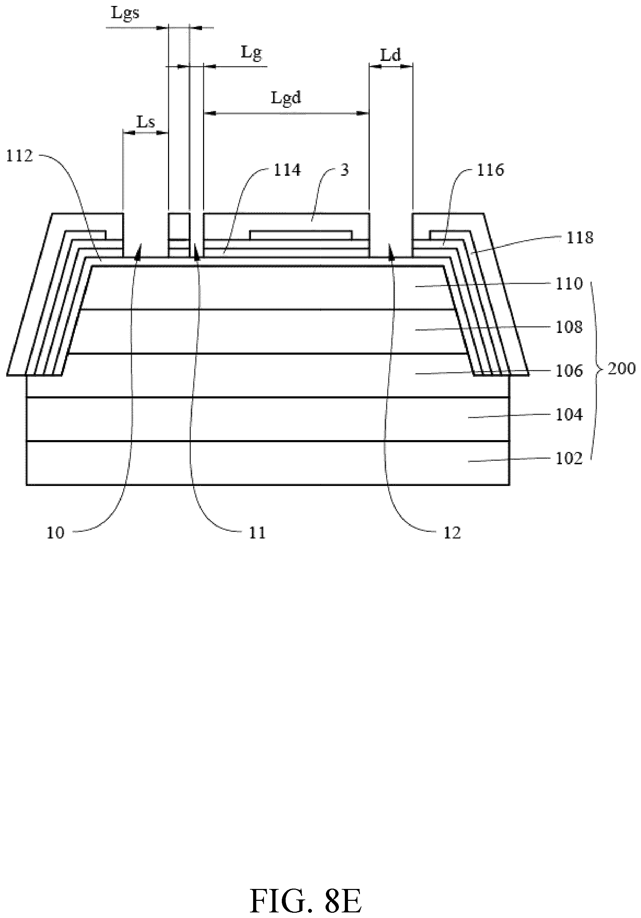

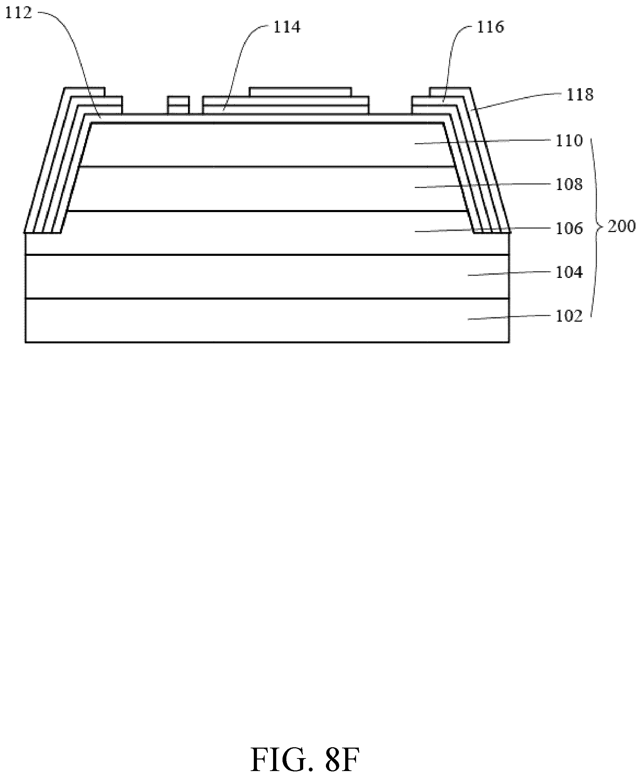

Please refer to FIG. 8A to FIG. 8F in conjunction with FIG. 1. FIG. 8A to FIG. 8F show structural changes that take place when step S110 is performed to pattern the first field plate 114 and the second field plate 118. First, referring to FIG. 8A to FIG. 8C, a suitable etching process is used together with a specific mask and/or photoresist (e.g., the photoresist 2 in FIG. 8A) to pattern the second field plate 118. After that, the photoresist 2 is removed to obtain a layered structure with the patterned second field plate 118. In a preferred embodiment of the present invention, the etching stop layer 116 is formed by LPCVD, and the second field plate 118 is formed by PECVD; thus, without being bound by any particular theory, the different properties of the two deposition processes allow selective etching to be carried out simply by adjusting the process parameters of the etching process, the objective being to stop the etching process at the etching stop layer 116, lest the first field plate 114 be etched by this etching process.

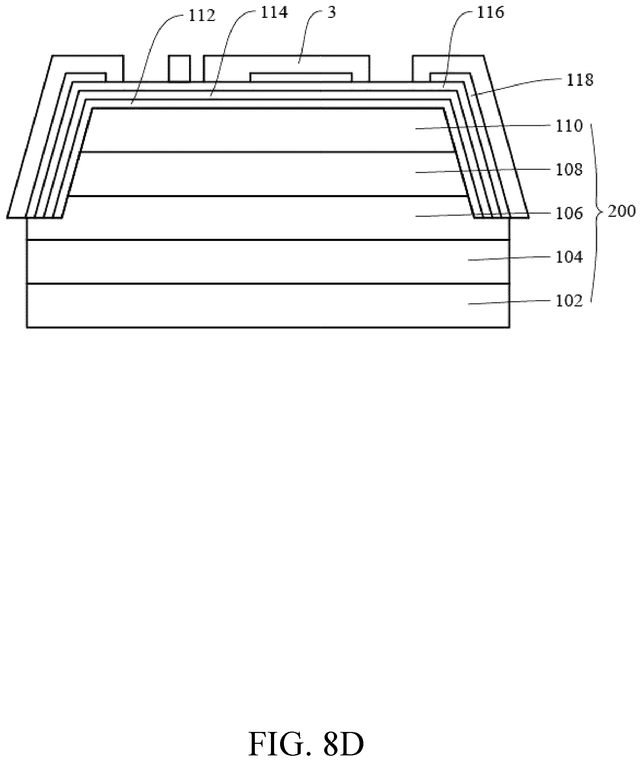

Next, referring to FIG. 8D to FIG. 8F, a suitable etching process is used together with a specific mask and/or photoresist (e.g., the photoresist 3 in FIG. 8D) to pattern the first field plate 114, thereby exposing the portions of the dielectric layer 112 that correspond to a source opening 10, a gate opening 11, and a drain opening 12. After that, the photoresist 3 is removed. In a preferred embodiment of the present invention, the source opening 10 has a length Ls in the range from 12 to 17 µm, such as any of the following values or a value between any two adjacent ones of the following values: 12 µm, 13 µm, 14 µm, 15 µm, 16 µm, or 17µm; preferably 15 µm. In another preferred embodiment of the invention, the gate opening 11 has a length Lg in the range from 1.0 to 2.5 µm, such as any of the following values or a value between any two adjacent ones of the following values: 1.0 µm, 1.5 µm, 2.0 µm, or 2.5 µm; preferably 1.5 µm. In yet another preferred embodiment of the invention, the drain opening 12 has a length Ld in the range from 15 to 25 µm, such as any of the following values or a value between any two adjacent ones of the following values: 15 µm, 17 µm, 19 µm, 21 µm, 23 µm, or 25 µm. In still another preferred embodiment of the invention, the distance Lgs between the source opening 10 and the gate opening 11 is in the range from 2.0 to 3.5 µm, such as any of the following values or a value between any two adjacent ones of the following values: 2.0 µm, 2.5 µm, 3.0 µm, or 3.5 µm; preferably 3.0 µm. In another preferred embodiment of the invention, the distance Lgd between the drain opening 12 and the gate opening 11 is in the range from 15 to 25 µm, such as any of the following values or a value between any two adjacent ones of the following values: 15 µm, 20 µm, or 25 µm; preferably 20 µm. In a preferred embodiment of the invention, the dielectric layer 112 is formed by LPCVD, and the first field plate 114 is formed by PECVD; thus, without being bound by any particular theory, the different properties of the two deposition processes allow selective etching to be carried out simply by adjusting the process parameters of the etching process, the objective being to stop the etching process at the dielectric layer 112.

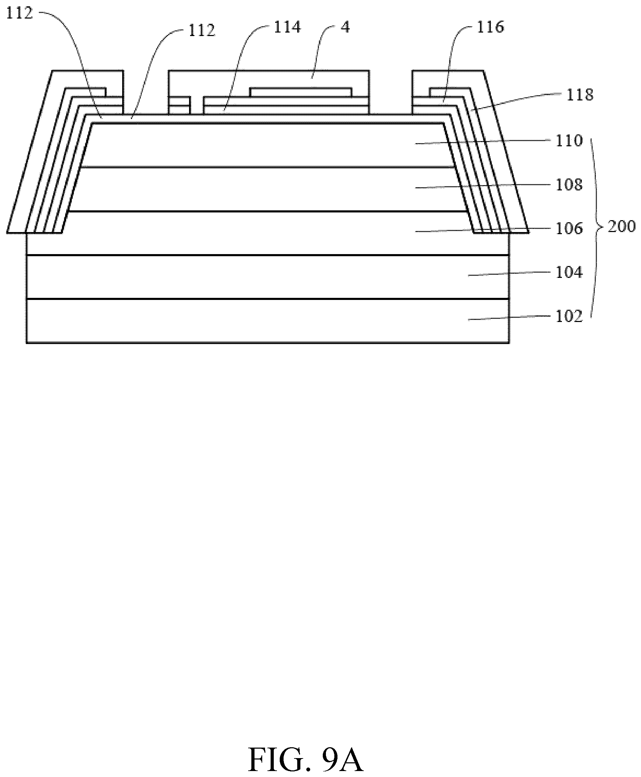

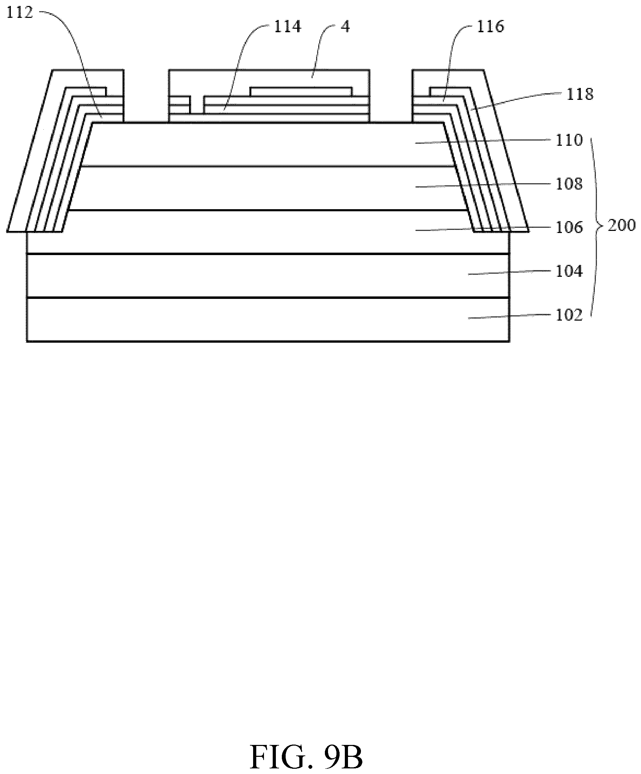

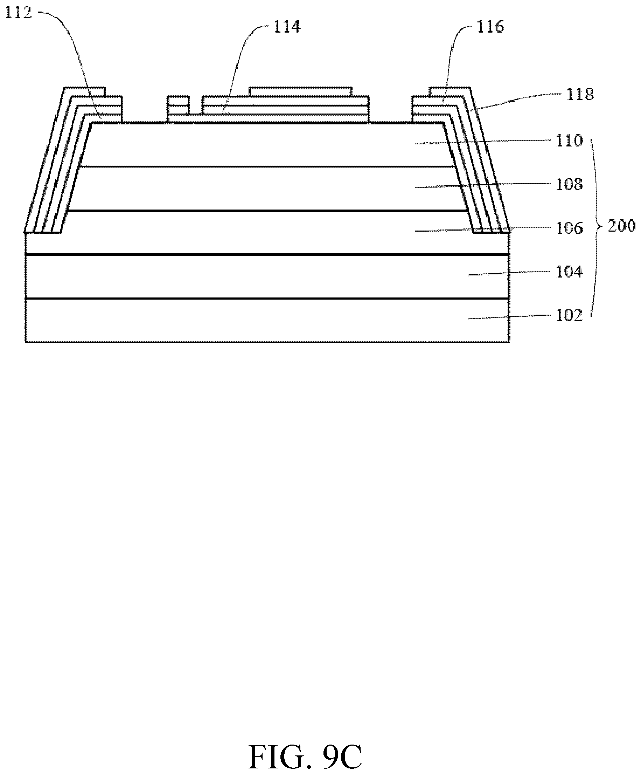

Please refer to FIG. 9A to FIG. 9C in conjunction with FIG. 1. FIG. 9A to FIG. 9C show structural changes that take place when the dielectric layer 112 is patterned in step S112 with a specific mask and/or photoresist. First, a specific photoresist 4 is applied. Next, a suitable etching process is used to perform downward etching above the portions of the dielectric layer 112 that are intended to form the source and the drain. The downward etching continues until the barrier layer 110 is reached, thus forming the source opening 10 and the drain opening 12 in the semiconductor substrate 200. After that, the photoresist 4 is removed.

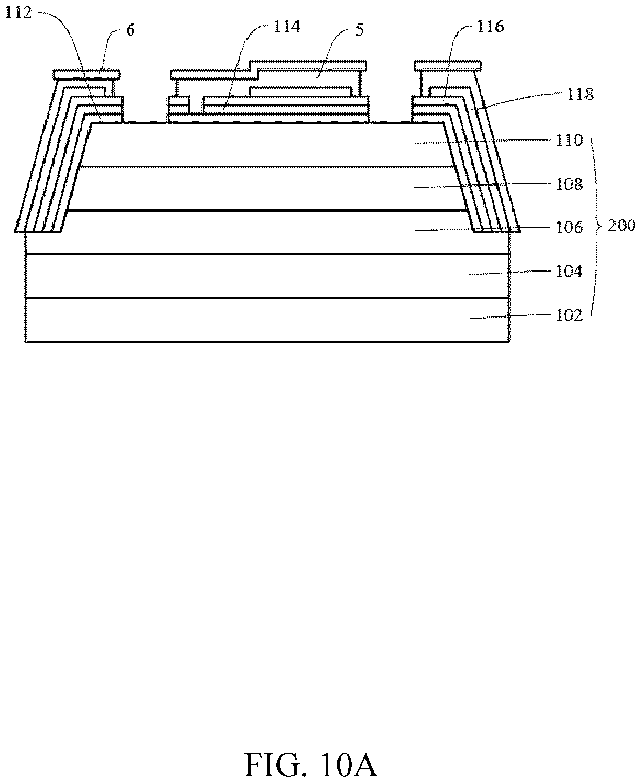

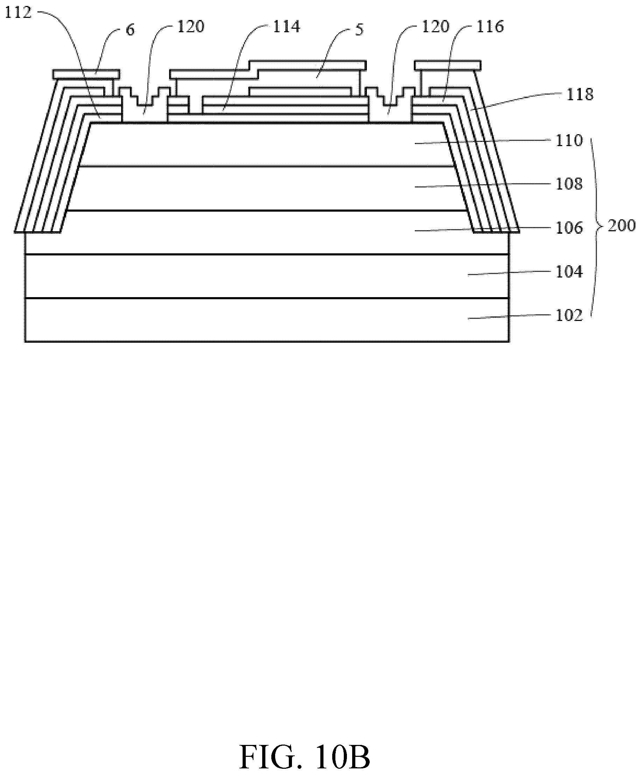

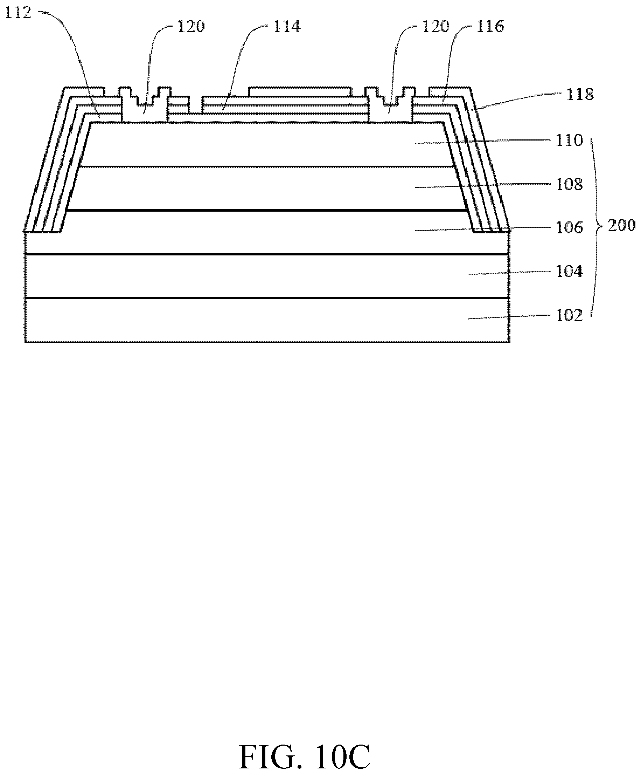

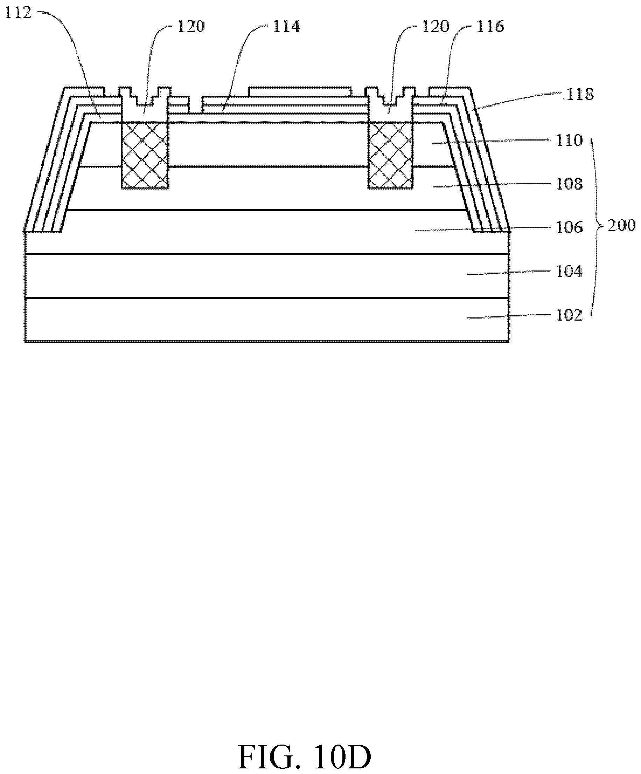

Please refer to FIG. 10A to FIG. 10C in conjunction with FIG. 1. FIG. 10A to FIG. 10C show structural changes that take place when step S114 is performed to form an ohmic-contact metal layer 120 in each of the source opening 10 and the drain opening 12 in a patterned manner and to alloy the ohmic-contact metal layer 120. Here, a suitable epitaxial growth or deposition process is used together with a suitable mask and/or photoresist (e.g., the photoresists 5 and 6 in FIG. 10A, with each photoresist being a different material) to form the ohmic-contact metal layer 120. Following that, the photoresists 5 and 6 are removed, and the objective of forming the ohmic-contact metal layer 120 in a restricted manner, i.e., in only the source opening 10 and the drain opening 12, is achieved. In a preferred embodiment of the present invention, the photoresist 6 is provided above the photoresist 5 and covers a larger area of the semiconductor substrate than the photoresist 5; thus, without being bound by any particular theory, the overhanging structures formed by the photoresists are effective in separating the ohmic-contact metal layer 120 formed in the source opening 10 and the drain opening 12 from the ohmic-contact metal layer 120 formed above the photoresists.

Next, an alloying process is used to alloy the ohmic-contact metal layer 120 formed in the source opening 10 and the drain opening 12, thereby forming the source and the drain as well as the ohmic contacts in the high-electron-mobility transistor. In a preferred embodiment of the present invention, the channel layer 108 is exposed through the bottom sides of the source opening 10 and of the drain opening 12, so the alloying process can be carried out at a process temperature substantially lower than that used in the prior art, preferably in the range from 300°C to 600°C, such as any of the following values or a value between any two adjacent ones of the following values: 300°C, 350°C, 400°C, 450°C, 500°C, 550°C, or 600°C. In another preferred embodiment of the invention, the ohmic contacts may be alternatively formed by forming a highly doped n-type GaN layer (not shown) above the bottom side of each of the source opening 10 and the drain opening 12, wherein the highly doped n-type GaN layer can enhance the resulting ohmic contacts, and wherein the carrier concentration of the highly doped n-type GaN layer is preferably higher than 10¹⁹ cm⁻³ and is more preferably raised above 10²⁰ cm⁻³ by molecular beam epitaxy (MBE). Without being bound by any particular theory, this alternative method can be used in place of, or to simplify, the alloying process, or to allow an even lower alloying process temperature (e.g., in the range from 300°C to 400°C) to be used. In the aforesaid preferred embodiment, step S102 (forming an isolated platform) may be immediately followed by: using a suitable etching process to perform downward etching at positions where the source and the drain are to be formed; continuing the downward etching until the channel layer 108 is reached, such that the source opening 10 and the drain opening 12 are formed in the semiconductor substrate 200; and then forming the n-type GaN layer by MBE. In some embodiments of the invention, the ohmic-contact metal layer 120 may be made of any suitable electrically conductive material that can form ohmic contacts or other electrically conductive junctions, preferably titanium (Ti)/aluminum (Al)/nickel (Ni)/tantalum (Ta)/molybdenum (Mo)/gold (Au).

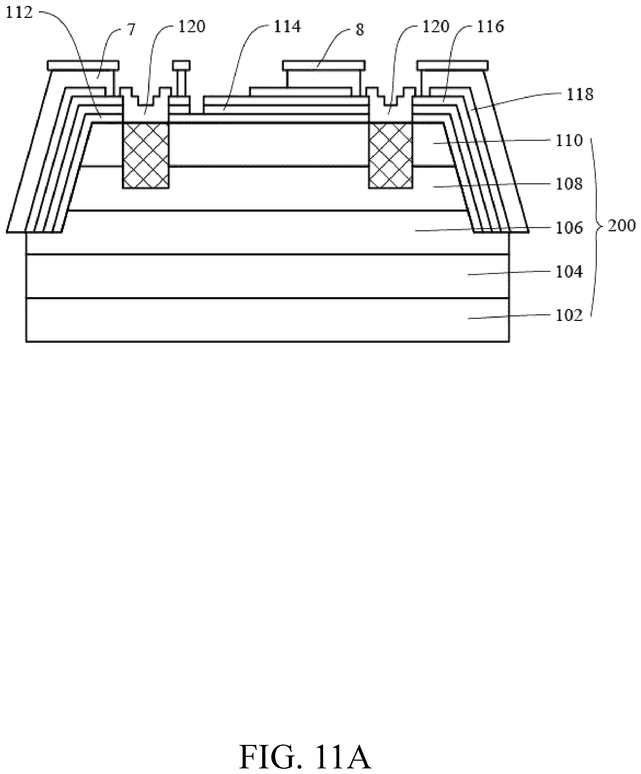

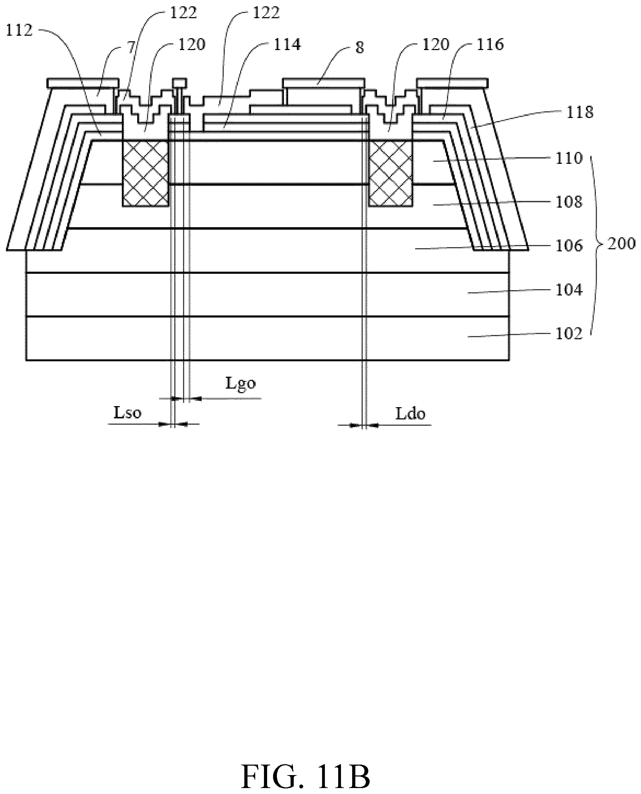

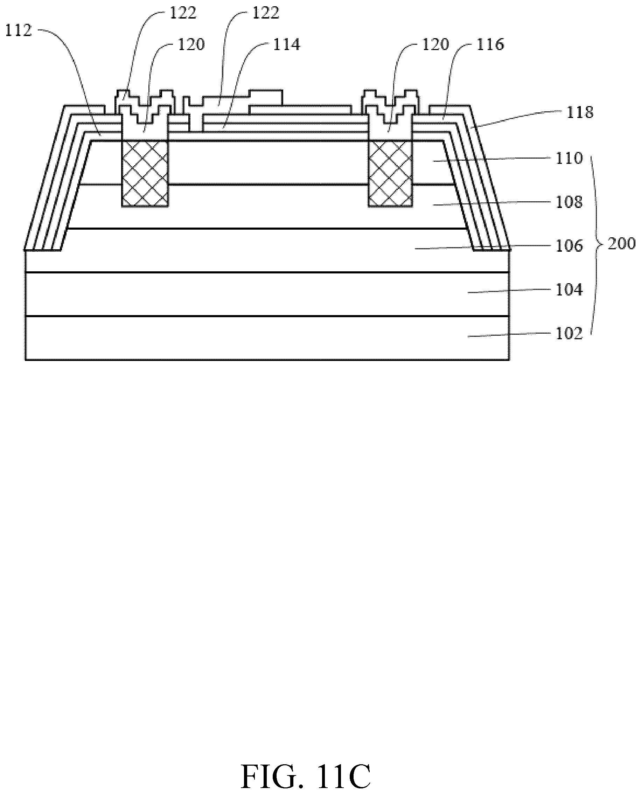

Please refer to FIG. 11A and FIG. 11B in conjunction with FIG. 1. FIG. 11A and FIG. 11B show structural changes that take place when step S116 is performed to form a metal layer 122 in a patterned manner. In this step, the metal layer 122 is formed in a patterned manner in order to cover the portions of the ohmic-contact metal layer 120 that correspond to the source opening 10 and the drain opening 12, the portion of the dielectric layer 112 that corresponds to the gate opening 11, a portion of the etching stop layer 116, and a portion of the second field plate 118. More specifically, a suitable epitaxial growth or deposition process is used together with a suitable mask and/or photoresist (e.g., the photoresists 7 and 8 in FIG. 11A, with each photoresist being a different material) to form the metal layer 112, and then the photoresists 7 and 8 are removed by a lift-off process to achieve the objective of forming the metal layer 122 in a patterned manner. In a preferred embodiment of the present invention, the photoresists 7 and 8 are provided in the same way as the photoresists 5 and 6 in FIG. 10A and form overhanging structures, too.

More specifically, the metal layer 122 covers the portion of the dielectric layer 112 that corresponds to the gate opening 11, and the gate is thus formed. The metal layer 122 also covers the portions of the ohmic-contact metal layer 120 that correspond to the source opening 10 and the drain opening 12, a portion of the etching stop layer 116, and a portion of the second field plate 118. The present invention, however, has no limitation above the sizes of the areas covered by the metal layer 122. In one embodiment of the invention, the protruding portion of the gate has a length Lgo in the range from 0.5 to 1.0 µm, such as any of the following values or a value between any two adjacent ones of the following values: 0.5 µm, 0.75 µm, or 1.0 µm; preferably 0.75 µm. In another embodiment of the invention, the protruding portion of the source has a length Lso in the range from 0.3 to 1.0 µm, such as any of the following values or a value between any two adjacent ones of the following values: 0.3 µm, 0.5 µm, 0.7 µm, 0.9 µm, or 1.0 µm; preferably 0.5 µm. In yet another embodiment of the invention, the protruding portion of the drain has a length Ldo in the range from 0.5 to 1.0 µm, such as any of the following values or a value between any two adjacent ones of the following values: 0.5 µm, 0.75 µm, or 1.0 µm; preferably 0.75 µm. Without being bound by any particular theory, using the metal layer 122 to cover the portions of the ohmic-contact metal layer 120 that correspond to the source opening 10 and the drain opening 12 helps thicken the source and the drain, thereby preventing series resistance from developing in the depletion-mode high-electron-mobility transistor. In some embodiments of the invention, the metal layer 122 may be made of any electrically conductive material that can apply a bias voltage to, or control, a semiconductor device, preferably nickel (Ni)/gold (Au) or zirconium (Zr)/gold (Au).

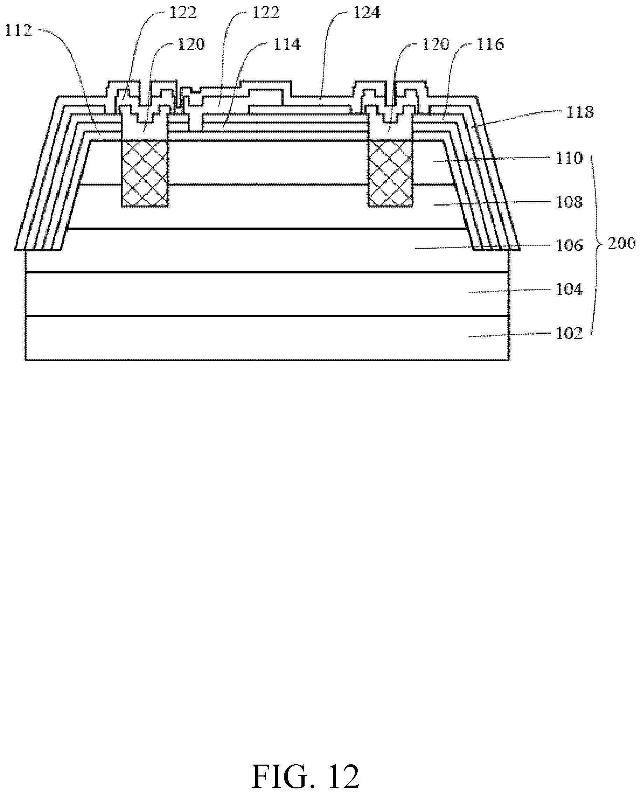

Please refer to FIG. 12 in conjunction with FIG. 1. FIG. 12 shows a structural change that takes place when step S118 is performed to form a protective layer 124 in a patterned manner. Here, a suitable epitaxial growth or deposition process is used together with a suitable mask and/or photoresist (not shown) to form the protective layer 124, and then the mask and/or photoresist is removed such that the protective layer 124 exposes the metal layer 122 in a restricted manner, i.e., exposes only portions of the metal layer 122 that correspond to the source opening 10 and the drain opening 12. In a preferred embodiment of the present invention, the thickness of the protective layer 124 is in the range from 1500 to 3500 Å, such as any of the following values or a value between any two adjacent ones of the following values: 1500 Å, 1700 Å, 1900 Å, 2100 Å, 2300 Å, 2500 Å, 2700 Å, 2900 Å, 3100 Å, 3300 Å, or 3500 Å. The material of the protective layer 124 includes a silicon oxide (SiOₓ) or a silicon nitride (SiNₓ), where x is in the range from about 0.1 to 1. The protective layer 124 preferably includes a silicon nitride.

In some embodiments of the present invention, the foregoing steps are preferably followed by providing a passivation layer (not shown) in a patterned manner. The passivation layer is formed by a suitable epitaxial growth or deposition process, is patterned with a specific mask and photoresist, and is made of an organic/inorganic dielectric material, wherein the organic/inorganic dielectric material is preferably at least one of silicon dioxide (SiO₂), a silicon oxynitride (SiONₓ), and a silicon nitride (SiNₓ), where x is in the range from about 0.1 to 1.

According to the above, the method provided by the present invention for making a depletion-mode high-electron-mobility transistor is such that the preparation of the various dielectric layers (including the aforesaid dielectric layer, first field plate, etching stop layer, and second field plate) can be completed before the ohmic-contact metal layer is formed, and that in consequence the choices of the epitaxial growth or deposition processes to be used will not be limited as in the case where the dielectric layers are prepared later than the ohmic-contact metal layer. This allows the invention to make proper use of the properties of different epitaxial growth or deposition processes so that the subsequent steps can dispense with expensive, complicated, and technically difficult manufacturing processes but still achieve precise control over selective etching.

While the present invention has been described above in detail, the embodiments disclosed herein are only some preferred ones of the invention and are not intended to be restrictive of the scope of the invention. In other words, equivalent changes and modifications can be made by a person of ordinary skill in the art without departing from the spirit or scope of the invention. All such changes and modifications shall fall within the scope of the patent protection sought by the applicant.

## Claims

1. A method for making a depletion-mode high-electron-mobility transistor, comprising the steps of:
(a) providing a semiconductor substrate, wherein the semiconductor substrate comprises a channel layer and a barrier layer provided above the channel layer;
(b) forming an isolated platform;
(c) forming a dielectric layer above the semiconductor substrate;
(d) forming a first field plate above the dielectric layer;
(e) forming a second field plate above the first field plate;
(f) patterning the first field plate and the second field plate in order to expose portions of the dielectric layer that correspond to a source opening, a gate opening, and a drain opening;
(g) patterning the dielectric layer in order to expose portions of the semiconductor substrate that correspond to the source opening and the drain opening; and
(h) forming an ohmic-contact metal layer in a patterned manner such that the ohmic-contact metal layer covers the portions of the semiconductor substrate that correspond to the source opening and the drain opening, and alloying the ohmic-contact metal layer.

2. The method of claim 1, further including the steps of:
(i) forming a metal layer in a patterned manner such that the metal layer covers not only portions of the ohmic-contact metal layer that correspond to the source opening and the drain opening, but also the portion of the dielectric layer that corresponds to the gate opening; and
(j) forming a protective layer in a patterned manner such that the protective layer exposes portions of the metal layer that correspond to the source opening and the drain opening.

3. The method of claim 2, wherein the protective layer comprises a silicon nitride and has a thickness in a range from 1500 to 3500 Å.

4. The method of any of the preceding claims, wherein the semiconductor substrate further includes a cap layer above the barrier layer.

5. The method of any of the preceding claims, wherein the step (b) of forming the isolated platform comprises an isolation implantation step.

6. The method of any of the preceding claims, wherein the step (c) of forming the dielectric layer uses a low-pressure chemical vapor deposition (LPCVD) process.

7. The method of any of the preceding claims, wherein the dielectric layer comprises a silicon nitride and has a thickness in a range from 450 to 750 Å.

8. The method of any of the preceding claims, wherein the step (d) of forming the first field plate uses a plasma-enhanced chemical vapor deposition (PECVD) process.

9. The method of claim 8, wherein the step (e) of forming the second field plate uses a plasma-enhanced chemical vapor deposition process.

10. The method of any of the preceding claims, wherein the first field plate comprises a silicon nitride and has a thickness in a range from 1500 to 3500 Å.

11. The method of any of the preceding claims, wherein the second field plate comprises a silicon nitride and has a thickness in a range from 2500 to 4000 Å.

12. The method of any of the preceding claims, wherein the step (d) further includes: forming an etching stop layer above the first field plate.

13. The method of claim 12, wherein said forming the etching stop layer uses a low-pressure chemical vapor deposition process, and the low-pressure chemical vapor deposition process uses a process temperature lower than 800°C.

14. The method of claim 12 or 13, wherein the etching stop layer comprises a silicon nitride and has a thickness in a range from 75 to 150 Å.

15. The method of any of the preceding claims, wherein in the step (h) of forming the ohmic-contact metal layer, said alloying uses a process temperature in a range from 300°C to 600°C.
